Europäisches Patentamt

European Patent Office

Office européen des brevets

(11) Numéro de publication: **0 148 706**
A2

# (12) DEMANDE DE BREVET EUROPEEN

(21) Numéro de dépôt: 84402740.9

(22) Date de dépôt: 27.12.84

(51) Int. Cl.⁴: **H 03 H 11/24**, H 03 H 7/25,
H 01 P 1/22, H 03 H 7/20

(30) Priorité: 10.01.84 FR 8400281

(43) Date de publication de la demande: 17.07.85
Bulletin 85/29

(84) Etats contractants désignés: AT CH DE GB IT LI NL SE

(71) Demandeur: THOMSON-CSF, 173, Boulevard
Haussmann, F-75379 Paris Cedex 08 (FR)

(72) Inventeur: Pavlidis, Dimitrios, THOMSON-CSF
SCPI 173, bld Haussmann, F-75379 Paris Cedex 08 (FR)
Inventeur: Archambault, Yves, THOMSON-CSF
SCPI 173, bld Haussmann, F-75379 Paris Cedex 08 (FR)
Inventeur: Magarshack, John, THOMSON-CSF
SCPI 173, bld Haussmann, F-75379 Paris Cedex 08 (FR)

(74) Mandataire: Taboureau, James et al, THOMSON-CSF
SCPI 173, Bld Haussmann, F-75379 Paris Cedex 08 (FR)

(54) Cellule à impédance contrôlable et circuit de contrôle de cette cellule.

(57) L'invention concerne une cellule, quadrupôle en $\pi$ ou en T, de type résistances-capacités, formant atténuateurs, déphaseurs, ou réactances variables. Cette cellule travaille en hyper-fréquences, et est réalisée en circuits intégrés sur matériaux III-V.

La cellule selon l'invention comporte des impédances ($Z_1$, $Z_2$, $Z_3$) montées en série et en parallèle entre les entrées (1, 2), et les sorties (3, 4) du quadrupôle. Ces impédances sont des transistors à effet de champ (T1, T2, T3) ou des diodes Schottky (D1, D2, D3) polarisées en inverse. Les deux tensions (V1, V2) de contrôle des impédances série et parallèle sont délivrées par un circuit de contrôle (5) qui, à partir d'une seule tension de commande ($V_{d1}$) fournit deux tensions variables de sortie (V1, V2) complémentaires.

Application comme impédances variables, déphaseurs, mélangeurs, aux radars et systèmes de télécommunications.

0148706

# CELLULE A IMPEDANCE CONTROLABLE ET CIRCUIT
## DE CONTROLE DE CETTE CELLULE

La présente invention concerne une cellule à impédance contrôlable, formant quadrupôle adapté en impédances en entrée et en sortie, réalisée en circuit intégré monolithique et fonctionnant dans le domaine des hyperfréquences. Cette cellule, qui, selon sa configuration, est un atténuateur, ou un déphaseur ou un commutateur, ces fonctions dérivant facilement les unes des autres, doit nécessairement être simple et intégrée pour pouvoir fonctionner aux très hautes fréquences. C'est donc une cellule, en $\pi$ ou en T, de type RC, dont les résistances sont des transistors à effet de champ non polarisés et dont les capacités sont des diodes Schottky polarisées en inverse. L'un des avantages de cette cellule est qu'elle est contrôlée, pour être adaptée en entrée et en sortie, par un circuit de contrôle qui fournit en sortie deux tensions de contrôle variables et complémentaires obtenues à partir d'une seule tension d'entrée variable. La cellule selon l'invention est donc commandée par une seule tension. Le circuit de contrôle fait partie intégrante de l'invention.

Les circuits intégrés monolithiques hyperfréquences donnent pour la première fois la possibilité d'associer plusieurs fonctions hyperfréquences sur la même pastille de circuit intégré. Le contrôle de l'amplitude et de la phase d'un signal par des tensions appliquées aux bornes de la pastille devient donc une nécessité pour le cheminement d'un signal à travers ces fonctions, qui sont par exemple l'amplification, l'atténuation, le déphasage, le mélange.

Mais en outre, étant donné qu'il s'agit d'hyperfréquences et que les longueurs de liaisons jouent un rôle considérable, il est préférable que ces cellules d'atténuateurs ou déphaseurs contrôlables par exemple soient de dimensions très réduites par rapport aux autres fonctions, et que les impédances soient adaptées pour perturber le moins possible les autres fonctions.

C'est pourquoi il est préférable que ces cellules à impédance contrôlable soient conçues de façon la plus simple possible, avec le moins de composants possibles et intégrées sur une pastille de circuit intégré sur la surface la plus petite possible.

Un déphaseur en bande S, intégré sur arséniure de gallium, est connu par la publication de IEEE International Solid State Circuits Conférence, février 1982, pages 134-135. Mais ce déphaseur a une structure si complexe et nécessite tant d'inductances que sa pastille de GaAs mesure 2 x 9 mm : de telles dimensions sont presque celles d'un circuit hybride, et, si elles conviennent encore à 2,5 - 3,5 GHz, elles ne conviendraient pas à 40 ou 50 GHz.

Par contre, la demande de brevet français n° 80 12439 du 4 juin 1980 décrit un déphaseur de très petites dimensions puisqu'il est constitué par un transistor à effet de champ doté de deux grilles, dont l'une sert de commande de déphasage du signal injecté sur l'autre grille.

La cellule selon l'invention est une cellule en π ou en T, de type RC résistances-capacités, dont les éléments, variables, sont commandables par une tension continue. Les résistances variables sont des transistors à effet de champ, non polarisés, commandés par une tension sur la grille. Les condensateurs variables sont des diodes Schottky polarisées en inverse. Pour obtenir une adaptation simultanée des impédances d'entrée et de sortie de ce quadrupôle, il faut appliquer deux tensions, variant de façon complémentaire, sur les deux branches, "horizontale" et "verticale" de la cellule en π ou en T.

Un aspect important de l'invention est que ces deux tensions sont obtenues à partir d'un circuit de contrôle très simple, intégré à la cellule et qui fournit deux tensions complémentaires, variant en sens inverse, à partir d'une seule tension de commande.

La cellule à impédance contrôlable, qui intègre son circuit de contrôle, est donc en fin de compte bien commandée par une seule tension. Elle ne comporte que trois transistors ou trois diodes (quatre transistors dans un cas où une résistance variable est coupée en deux) et la conception du circuit de contrôle, qui ne comporte que deux transistors et deux résistances, fait que les selfs de chocs, généralement associées aux alimentations en hautes fréquences, ne sont pas nécessaires parce que le circuit de contrôle a lui même une impédance élevée.

De façon plus précise, l'invention concerne une cellule à impédance contrôlable, de type résistances-capacités, dont les impédances variables sont des composants actifs commandés par une tension, cette cellule étant caractérisée en ce que l'impédance aux bornes d'entrée et l'impédance aux bornes de sortie de la cellule sont contrôlées par une unique tension, par l'intermédiaire d'un circuit de contrôle, qui, à partir d'une tension variable, délivre deux tensions de contrôle variables complémentaires dont l'une contrôle l'impédance d'entrée, et dont l'autre contrôle l'impédance de sortie de la cellule.

L'invention sera mieux comprise grâce à la description suivante de plusieurs exemples de cellule, en regard des figures annexées qui représentent :

- figures 1 et 2 : schémas de bases de la cellule selon l'invention,

- figure 3 : schéma d'une cellule formant atténuateur adapté, selon l'invention,

- figure 4 : variante de l'atténuateur de la figure 3, avec transistors sans grilles,

- figures 5 et 6 : deux schémas de cellule formant résistance ou réactance variables,

- figures 7, 8, 9 : trois exemples d'implantation monolithique de la cellule selon l'invention,

- figure 10 : diagramme représentant les variations relatives des deux tensions de sorties en fonction de la tension de commande,

- figure 11 : schéma électrique du circuit selon l'invention,

- figures 12 et 13 : schéma d'un montage de linéarisation de la tension de sortie, et sa courbe représentative,

- figures 14 et 15 : autre schéma d'un montage de linéarisation de la tension de sortie et sa courbe représentative,

- figure 16 : schéma électrique d'un circuit plus complexe, regroupant plusieurs circuits selon l'invention, doté en sortie de montages de linéarisations,

- figure 17 : schéma électrique d'un exemple de cellule selon l'invention, regroupant un atténuateur adapté et le circuit de contrôle.

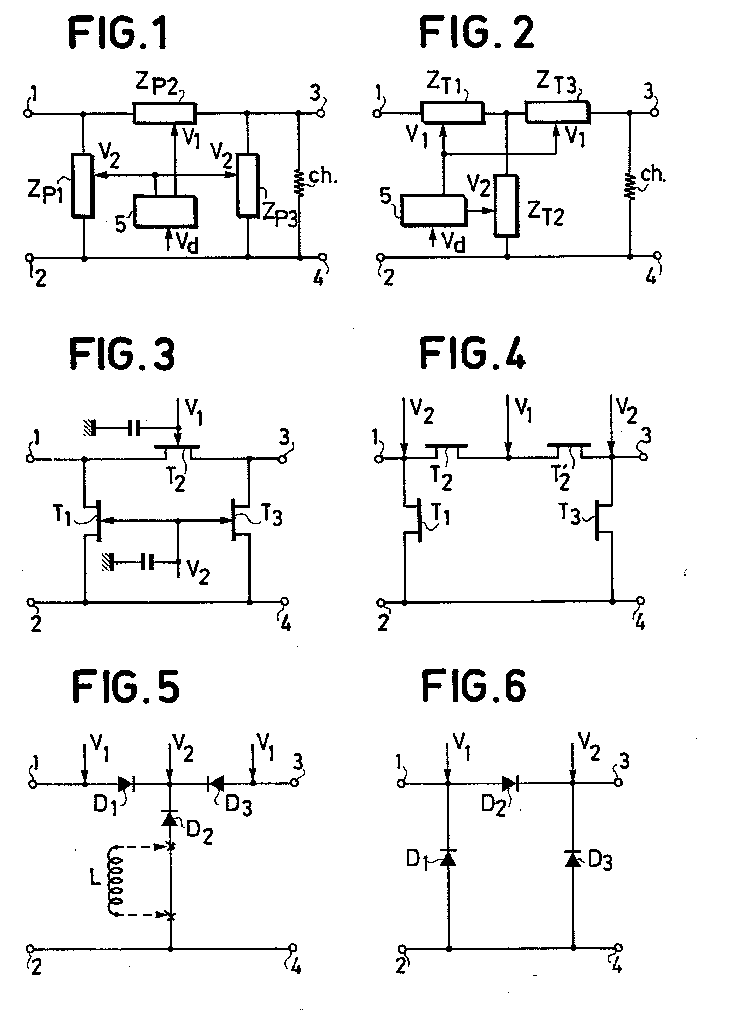

Les figures 1 et 2 représentent les deux schémas de base de la cellule selon l'invention. Sur la figure 1, le quadrupôle est en $\pi$, et sur la figure 2 il est en T. Ces montages sont classiques.

Les signaux hyperfréquences entrent sur les bornes d'entrées 1 et 2 de la cellule, et sortent par les bornes de sorties 3 et 4 sur une charge résistive, normalisée à 50 ohms par exemple. Les impédances variables $Z_{Pi}$ pour le schéma en $\pi$, ou $Z_{Ti}$ pour le schéma en T, sont des résistances variables ou des capacités variables, commandables par des tensions variables $V_1$ et $V_2$.

Un aspect remarquable de l'invention est que les valeurs requises pour les impédances $Z_{Pi}$ ou $Z_{Ti}$ sont obtenues au moyen d'une tension de commande $V_d$ unique, appliquée à un circuit de contrôle 5, qui délivre les deux tensions de contrôle $V_1$ et $V_2$ complémentaires. En effet, les impédances $Z_1$ et $Z_3$, d'entrée et de sortie de la cellule, et l'impédance $Z_2$, interne à la cellule, évoluent de manière divergente, les unes augmentant tandis que l'autre diminue, ou réciproquement, et les tensions de contrôle $V_1$ et $V_2$ évoluent également de manière divergente, et cependant ces deux évolutions dans des sens opposés sont obtenues, par l'intermédiaire du circuit de contrôle 5, au moyen d'une seule tension de commande $V_d$.

Le circuit de contrôle sera analysé ultérieurement.

La figure 3 représente le schéma d'une cellule à impédances variables, faisant atténuateur adapté, selon l'invention. Le circuit de contrôle n'y est pas représenté, mais les tensions de contrôle de la cellule sont celles qui en sont issues.

Dans ce quadrupôle, de bornes d'entrées 1 et 2 et de bornes de sorties 3 et 4, les trois éléments formant atténuateur en $\pi$ sont des transistors à effet de champ, non polarisés. Pour une réalisation en circuit intégré sur GaAs, ce sont préférentiellement des MESFETS, ou des MISFETS ou des MOSFETS plutôt que des transistors à jonctions. Le transistor T2, en série entre l'entrée 1 et la sortie 3 – l'entrée 2 et la sortie 4 étant le plus souvent le plan de masse – est commandé par une tension V1 issue du circuit de contrôle, tandis que le transistor T1 en parallèle sur les entrées 1-2 et le transistor T3, en parallèle sur les sorties 3-4, sont commandés par une seconde tension V2 issue du même circuit de contrôle.

Comme le circuit de contrôle délivre, à partir d'une seule tension d'entrée de commande $V_d$ deux tensions de sorties de contrôle $V_1$ et $V_2$

complémentaires et qui évoluent en sens inverse, lorsque la tension $V_1$ tend à bloquer le transistor T2, la tension V2 tend à rendre passants les transistors T1 et T3, et réciproquement.

Une particularité de la cellule à impédances variables de l'invention, est qu'il n'est pas nécessaire de prévoir des selfs de choc sur les tensions de contrôle des grilles des transistors. L'absence de selfs de choc permet une économie de surface considérable dans l'intégration sur une pastille de GaAs.

La figure 4 représente une variante de l'atténuateur de la figure 3. Selon cette variante, les transistors sont des transistors à effet de champ sans grille, c'est-à-dire qu'ils se comportent comme des résistances actives ou saturables.

Par rapport à une résistance pure, dont la courbe intensité en fonction de la tension est une droite (V = RI), une résistance saturable a une courbe dans laquelle l'intensité tend vers une asymptote lorsque la tension augmente. Cette courbe est très comparable à celle d'un transistor à effet de champ pour lequel la tension appliquée sur la grille est nulle, $V_G = 0$. La valeur d'une résistance saturable est donc fonction de la tension appliquée à ses bornes.

Dans le schéma de la figure 4, les transistors T1 et T3, en parallèle sur l'entrée et la sortie, qui sont des transistors sans grilles se comportant en résistances saturables, sont commandés par une tension V2 appliquée à leurs bornes, c'est-à-dire en fait sur la borne d'entrée 1 et sur la borne de sortie 3, respectivement.

Mais si l'impédance variable qu'est le transistor série T2 était maintenue telle que représentée en figure 3, elle ne serait soumise à aucune tension de commande, puisque la même tension V2 est appliquée à ses bornes. C'est pourquoi cette impédance est, dans le cas de la figure 4 et des résistances saturables, divisée en deux parties, deux transistors T2 et T'2 sans grilles. Une tension de contrôle V1 est appliquée au point commun entre les deux transistors, chaque transistor étant ainsi soumis à une différence de tension $|V1 - V2|$.

Le fait de n'avoir pas de grille permet de réaliser des transistors plus petits et donc facilite l'augmentation de densité en intégration hyperfréquence. Il permet également un fonctionnement à une fréquence plus élevée à cause de la diminution de la capacité parasite

Les figures 5 et 6 représentent deux autres schémas de la cellule à impédances variables de l'invention, formant résistance ou réactance variables, adaptées selon les valeurs des tensions de contrôle V1 et V2.

Les condensateurs qui sont normalement utilisés dans ces schémas en $\pi$ ou en T sont obtenus, dans le cas de l'intégration hyperfréquence sur GaAs, par des diodes polarisées en inverse. Ainsi, dans le cas du circuit en T de la figure 5, les diodes D1 et D3, montées en série entre l'entrée 1 et la sortie 3, sont polarisées par les différences de tensions | V1 - V2 | et la diode parallèle D2 est polarisée par la différence de tension V2 - masse. Par contre, dans le cas du circuit en $\pi$ de la figure 6, la diode série D2 est polarisée par la différence | V1 - V2 | et les diodes parallèles D1 et D3 par les différences V1 - masse et V2 - masse respectivement.

Un cas intéressant est celui de la figure 5 : par adjonction d'une self L entre la diode D2 et le commun entrée 2 - sortie 4 du circuit en T, et en faisant V1 = 0 V, ce circuit constitue un déphaseur adapté, variable, commandé par la seule tension V2.

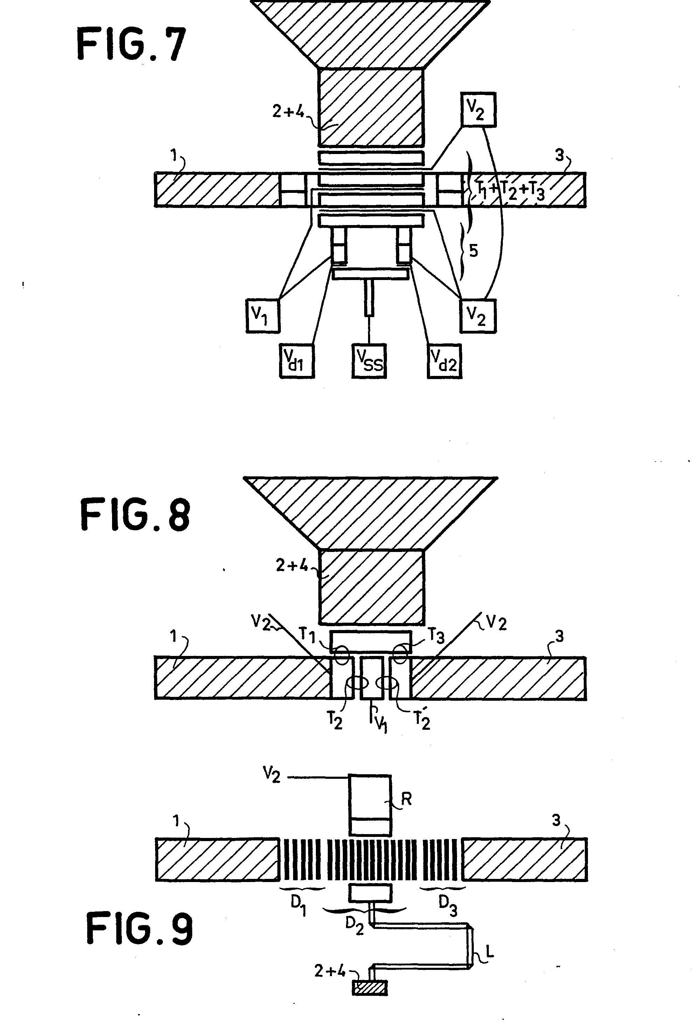

Les figures 7, 8 et 9 représentent trois exemples d'implantation monolithique sur GaAs de la cellule à impédance contrôlable selon l'invention.

La figure 7 représente un atténuateur en $\pi$ selon la figure 3. Les trois transistors T1, T2 et T3 y apparaissent, au centre de la figure, sous la forme de trois métallisations fines et quatre métallisations épaisses : ce sont les trois grilles contrôlées par les tensions V1 et V2, et les sources et drains des transistors, qui sont communs deux à deux. L'entrée du circuit est prise sur la métallisation 1, en contact ohmique avec la métallisation drain de T1 et source de T2. La sortie est prise sur la métallisation 3, en contact ohmique avec la métallisation drain de T2 et drain de T3. L'entrée-sortie commune est le plan de masse 2+4. Le circuit 5 est le circuit de contrôle qui sera décrit ultérieurement et qui, à partir d'une seule tension $V_{d1}$ variable, fournit deux tensions de sortie V1 et V2 variables complémentaires.

La figure 8 représente un atténuateur en $\pi$ selon la figure 4, dans laquelle les transistors, sans grilles, se comportent en résistances actives. Chaque transistor apparaît donc sous la forme de deux métallisations, recouvrant partiellement une couche de matériau semiconducteur épitaxiée ou implantée, sans métallisation de grille. Les quatre transistors T1, T2 et T'2, et T3 sont mis en évidence sur la figure 8 par des cercles. Le circuit de contrôle 5, qui fournit les tensions de contrôle V1 et V2, n'est pas représenté sur ce dessin.

La figure 9 représente un déphaseur en T selon la figure 5, dans le cas où V1 = 0 et où une self L est intercalée entre la diode D2 et le commun entrée – sortie 2-4. Une résistance R est également intercalée entre la source de tension V2 et les diodes. Une diode Schottky est obtenue par une métallisation adéquate – donnant un contact redresseur – sur une couche de matériau semiconducteur. Les trois diodes D1, D2 et D3 sont réalisées sous forme d'une métallisation en peigne, et comme ces trois diodes ont une cathode commune, la métallisation en peigne est leur cathode commune. Des contacts ohmiques avec la couche de matériau semiconducteur du circuit intégré sont pris par la métallisation 1 pour l'entrée, la métallisation 3 pour la sortie ; la résistance R, pour la tension de commande, prend un contact sur la métallisation Schottky commune aux trois diodes, et le commun entrée-sortie 2-4 est pris à l'extrémité de la self L.

Le même circuit qu'en figure 9, dans lequel la self L et la résistance R sont supprimées, mais une tension de contrôle V2 appliquée aux anodes des diodes D1 et D3, c'est-à-dire à l'entrée 1 et à la sortie 3, devient une résistance ou une réactance variable, selon les valeurs de V1 et V2.

Une particularité de la cellule à impédance contrôlable selon l'invention, qui ressort des figures 7, 8 et 9, est son extrême compacité : la majeure partie de la surface de la pastille de circuit intégré est occupée par les liaisons d'entrées-sorties 1, 2, 3 et 4, même si l'on ajoute aux figures 8 et 9 le circuit de contrôle 5 qui n'y est pas représenté.

Ce circuit de contrôle, qui n'a pas encore été décrit, délivre simultanément deux tensions de sorties complémentaires, c'est-à-dire deux tensions qui évoluent en sens inverse et dont la somme reste constante. Ces deux tensions réglables sont obtenues par une tension de commande, et lorsque la tension de commande varie, les deux tensions de sortie du circuit varient en sens opposés ce qui en fait bien des tensions complémentaires.

Dans le circuit de contrôle selon l'invention, la variation des tensions appliquées aux bornes des résistances est obtenue, à partir d'une tension unique, par l'intermédiaire de deux transistors montés en différentiel, dont l'un est commandé par une tension fixe et l'autre par une tension unique variable. L'alimentation négative $V_{SS}$ est appliquée à travers une impédance élevée, obtenue par une résistance de forte valeur ou un transistor monté en source de courant, ce qui permet de contrôler le courant débité à travers les deux transistors montés en différentiel. Selon la valeur de la tension de commande par rapport à la tension fixe, le courant passe préférentiellement par l'un ou par l'autre transistor, et les tensions aux bornes des résistances évoluent dans le même sens que les courants dans les transistors.

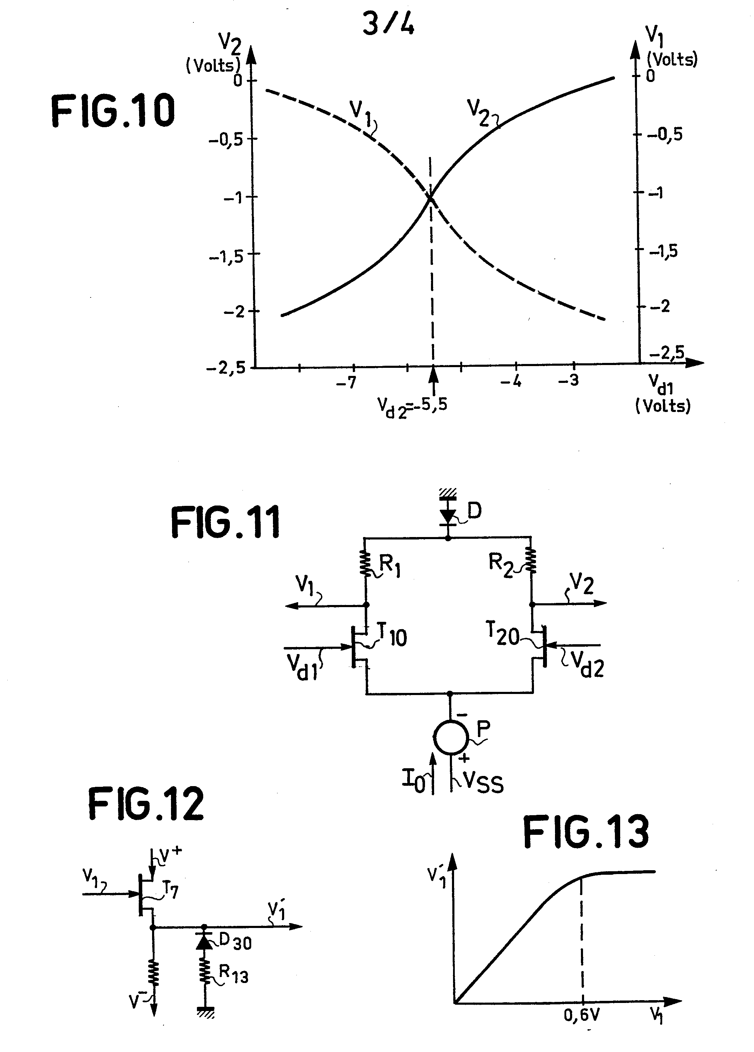

La figure 10 représente le double diagramme de variation relative des deux tensions de sorties du circuit électronique selon l'invention, en fonction de la tension de commande. Si V1 est la tension de sortie d'une première sortie du circuit, et V2 la tension de sortie de la seconde sortie du circuit, ces deux tensions V1 et V2 évoluent en sens opposés lorsque la tension de commande $V_{d1}$ évolue. La tension de commande est appliquée sur un premier transistor d'une paire de transistors montés en différentiel, cependant qu'une tension fixe $V_{d2}$ est appliquée sur le second transistor de la paire différentielle. Le point de croisement entre les tensions de sorties V1 et V2 est fonction de la valeur de la tension fixe $V_{d2}$. Ainsi, selon la valeur de $V_{d2}$, les deux courbes représentatives de V1 et V2 peuvent être symétriques sur le diagramme, ou bien être divergentes, c'est-à-dire que leur point commun se situerait sur le diagramme de la figure 1 à une valeur faible de la tension de commande $V_{d1}$, et les deux courbes ont un point de croisement situé sur la droite de la figure. Elles peuvent encore être convergentes, c'est-à-dire que les deux courbes ont un point de croisement situé à gauche de la figure pour une valeur élevée de la tension de commande $V_{d1}$. La valeur relative de la tension fixe $V_{d2}$ par rapport à la tension de commande $V_{d1}$ détermine une certaine asymétrie des deux courbes représentatives de V1 et V2 en fonction de la tension de commande $V_{d1}$. Les tensions représentées sur la figure 10 sont des tensions négatives, parce que cette figure correspond à la réalité de la figure 11, dans laquelle le schéma électrique adopte des transistors à effet de champ.

En fait, le circuit selon l'invention peut être réalisé avec n'importe quels types de transistors, qu'ils soient bipolaires pnp ou npn, que ce soient des transistors à effet de champ, ou même que ce soient des transistors de signaux ou de puissance, dans un cadre plus général que le seul contrôle de la cellule à impédance contrôlable décrite ci-dessus.

La figure 11 représente le schéma électrique du circuit selon l'invention qui permet d'obtenir deux tensions de sortie V1 et V2 dont les variations sont représentées en figure 10.

Ce circuit comporte deux branches symétriques, montées en parallèle entre une source d'alimentation $V_{SS}$, schématisée par le symbole de la source de tension P, et la masse. Chacune des deux branches comporte, à partir de la source d'alimentation, un transistor T10 (ou T20) en série avec une résistance R1 (ou R2 selon la branche). Pour une première branche, celle qui comporte le transistor T10 et la résistance R1, une tension de commande $V_{d1}$ est appliquée sur la grille du transistor T10. Pour la seconde manche, celle qui comporte le transistor T20 et la résistance R2, une tension fixe $V_{d2}$ est appliquée sur la grille du transistor T20. Les deux tensions de sortie V1 et V2 sont recueillies en un point situé d'une part entre le transistor T10 et la résistance R1, d'autre part entre le transistor T20 et la résistance R2.

Les transistors T10 et T20 peuvent être montés avec la source reliée à l'alimentation et le drain relié à la résistance ou inversement. De la même façon, si les transistors étaient des transistors bipolaires npn ou pnp, ils seraient montés de façon convenable pour l'homme de l'art entre l'alimentation P et la masse.

Si l'on considère les deux tensions $V_{d1}$ variable et $V_{d2}$ fixe, lorsque $V_{d1} = V_{d2} - |V|$, le transistor T10 est relativement plus bloqué que le transistor T20, le courant $I_0$ passe préférentiellement à travers le transistor T20, et la tension de sortie V2 augmente. Pour une tension de commande $V_{d1}$ suffisamment élevée, la tension de sortie V1 délivrée aux bornes de la résistance R1, par le transistor T10, tend vers 0 et simultanément la tension V2 délivrée aux bornes de la résistance R2 par le transistor T20 tend vers $R_2 I_0$.

Inversement, lorsque $V_{d1} = V_{d2} + |V|$, le courant s'écoule préférentiellement à travers le transistor T10, et pour une tension de commande $V_{d1}$

suffisamment petite, la tension de sortie V2 tend vers 0 tandis que la tension de sortie V1 tend vers $R_1 I_0$.

La dissymétrie entre les caractéristiques des tensions de sortie V1 et V2 pour R1 = R2 est corrigée en choisissant des valeurs de résistances légèrement différentes. Cette dissymétrie est introduite par la dissymétrie qu'il y a à l'origine entre les tensions appliquées sur les grilles des deux transistors T10 et T20.

Ce circuit de commande, fournissant deux tensions de sorties, est préférentiellement intégré sur une pastille de matériaux semiconducteurs, et il est préférable de monter une diode en inverse entre la masse et le point commun du circuit, de façon à éviter les retours de tension.

Il a été dit que la source de courant a une impédance de forte valeur, de l'ordre de 2000 Ohms. Cette impédance peut être obtenue en montant entre l'alimentation P et le circuit une résistance de l'ordre de 2000 Ohms. Elle peut également être obtenue en montant un transistor dont la grille - puisque dans le cas présent, l'invention est exposée en s'appuyant sur des transistors à effet de champ - est réunie au drain de façon à constituer une forte résistance. La valeur d'impédance du circuit permet de contrôler la répartition du courant $I_0$ à travers les deux transistors T10 et T20.

A partir de ce schéma simple regroupant deux transistors formant une paire différentielle, il est possible de réaliser des circuits plus complexes, puisque ce circuit est cascadable. Un montage plus complexe s'impose s'il est nécessaire de commander des fonctions d'atténuation en modulation vectorielle, par exemple, ou s'il est nécessaire d'obtenir plus que deux tensions qui évoluent simultanément.

Il a été dit que les tensions de sortie présentent une certaine dissymétrie liée à la valeur relative des tensions fixes $V_{d2}$ et de commande $V_{d1}$. Une linéarisation des caractéristiques de tension de sortie en fonction de la tension de commande est possible en ajoutant des réseaux de correction, branchés sur les sorties du circuit.

La figure 12 représente un premier réseau de linéarisation, et la figure 13, qui doit se lire conjointement avec la figure 12, donne la courbe représentative de cette linéarisation.

S'il est nécessaire d'obtenir une caractéristique linéaire dans une gamme de tension faible, par exemple entre 0 et 0,6 V, la tension de sortie V1 par exemple est appliquée sur la grille d'un transistor T7, convenablement polarisé. Sur le drain de ce transistor est monté un circuit correcteur qui comporte une diode D30, en série avec une résistance R13, mise à la masse. La cathode de la diode est connectée au drain du transistor T7. La tension de sortie V'1 linéarisée est prélevée à la cathode de la diode D30. La linéarisation de la tension de sortie V'1 est représentée sur la figure 13. Pour un montage avec une diode en parallèle comme représenté en figure 12, la tension de sortie V'1 est linéaire en fonction de V1 entre 0 et 0,6 V.

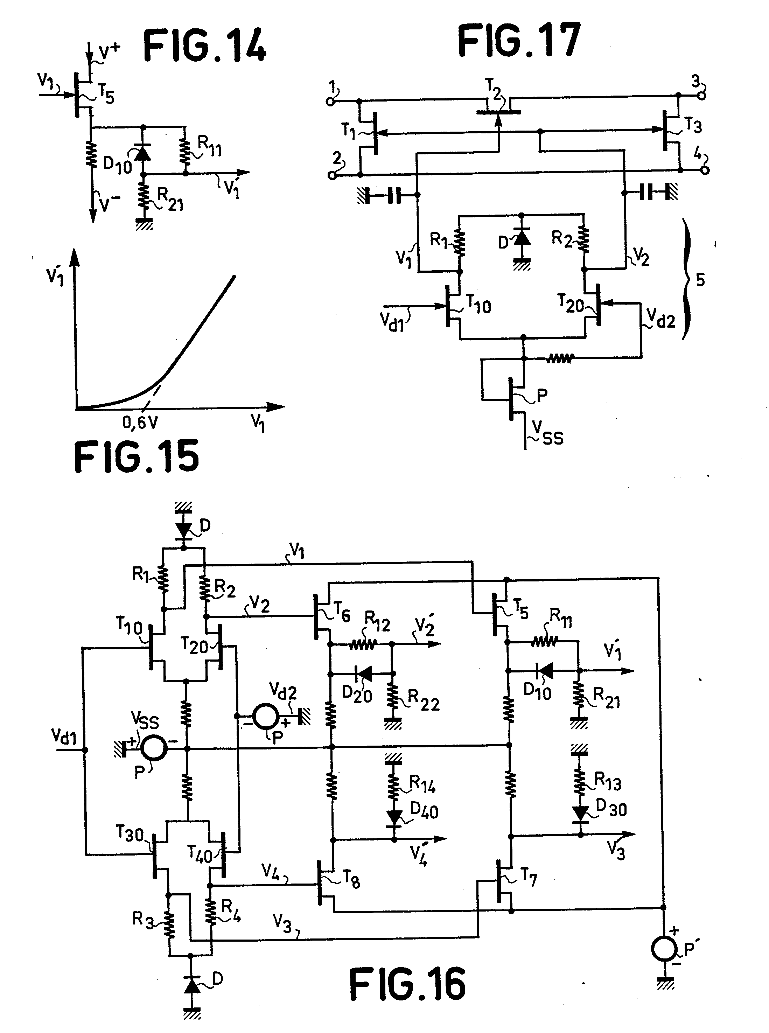

La figure 14 représente un autre schéma de linéarisation de la tension de sortie, mais cet autre schéma s'applique comme cela est représenté en figure 15 à une tension de sortie supérieure à 0,6 V.

La tension de sortie V1, issue du schéma de la figure 11 est appliquée sur la grille d'un transistor T5 convenablement polarisé. Sur le drain de ce transistor est monté un circuit correcteur qui comporte une diode D10, en série avec une résistance R21 mise à la masse. Une seconde résistance R11 est montée en parallèle avec la diode D10, dont la cathode est connectée au drain du transistor T5. La tension de sortie V'1 linéarisée est prélevée à l'anode de la diode D10. La figure 15 représente la linéarisation de la tension de sortie V'1 pour des tensions de V1 supérieures à 0,6 V.

A titre d'exemple, qui ne limite pas la portée de l'invention, les résistances ont les valeurs suivantes : R13 = 100 ohms, R11 = 4000 ohms, R21 = 2000 ohms. En plus, la résistance qui est branchée sur la polarisation des transistors T7 et T5, dans les deux cas de figures 12 et 14, a une valeur de 3500 à 4000 ohms.

La figure 16 représente un circuit d'alimentation plus complexe que ceux représentés jusqu'à présent en figures 11, 12 et 14, mais il regroupe en fait plusieurs circuits selon l'invention.

Si on ne considère que la partie gauche de la figure 16, on voit que deux circuits d'alimentation sont montés en cascade. Le premier regroupe la paire différentielle T10, T20 et les résistances R1 et R2, cependant que le second regroupe la paire différentielle T30, T40 et les résistances R3 et R4. Ces deux circuits sont alimentés par une tension commune $V_{SS}$, et com-

0148706

12

mandés par une tension de commande $V_{d1}$ commune, la tension fixe $V_{d2}$ étant également commune. Bien entendu, il est possible de monter autant de circuits d'alimentation que nécessaires en parallèle : les deux circuits représentés en figure 16 délivrent quatre tensions de sortie V1, V2, V3 et V4, complémentaires deux à deux et, en regroupant trois ou quatre circuits, on obtiendrait 6 ou 8 tensions de sortie complémentaires deux à deux.

Sur la partie droite de la figure 16, sont montés quatre circuits de linéarisation. Intentionnellement deux circuits sont destinés à linéariser les tensions de sorties au dessus de 0,6 V, tandis que les deux autres sont destinés à linéariser en dessous de 0,6 V.

Les deux circuits regroupant le transistor T5 et la diode D10 d'une part, le transistor T6 et la diode D20 d'autre part, recueillent les tensions de sortie V1 et V2 respectivement. Les tensions de sortie V'1 et V'2 sont linéarisées au dessus de 0,6 V. Par contre, les deux circuits regroupant le transistor T7 et la diode D30 d'une part, le transistor T8 et la diode D40 d'autre part, recueillent les tensions de sortie V3 et V4, de la seconde paire différentielle, respectivement. Les tensions de sortie V'3 et V'4 sont linéarisées en dessous de 0,6 V, et elles sont complémentaires.

La source de tension P' sert à polariser les transistors des circuits de linéarisation. Les deux diodes D montées chacune entre la masse et une paire différentielle de transistors servent à un décalage de tension, par rapport aux transistors de circuits de linéarisation.

La figure 17 représente un exemple de cellule à impédance contrôlable selon l'invention : c'est le schéma électrique de la figure 7, et elle regroupe un atténuateur en π selon la figure 3, et le circuit de contrôle selon la figure 11, commun à toutes les cellules conformes à l'invention.

Cette figure 17 fait ressortir, mieux que les figures 3 à 6, que la cellule à impédance contrôlable d'entrées 1-2 et de sorties 3-4 est contrôlée par une seule tension $V_{d1}$. Son intérêt en intégration ressort bien de la figure 7.

La cellule selon l'invention, dotée de son circuit de contrôle, a de nombreux domaines d'application : comme impédance variable pour adaptation dynamique, dans les mélangeurs, pour le contrôle de phase et d'amplitude de l'oscillateur local, dans les détecteurs de phase et discriminateurs, destinés plus particulièrement aux matériels qui travaillent en hyperfréquences : antennes, radars, télécommunications, ou instrumentation.

Elle est plus particulièrement intéressante dans sa forme intégrée sur une pastille de GaAs ou de matériaux de la famille III-V.

14

REVENDICATIONS

1/ Cellule à impédance contrôlable, de type résistances-capacités, dont les impédances variables $(Z_1, Z_2, Z_3)$ sont des composants actifs $(Z_1, Z_2, Z_3)$ commandés par une tension, cette cellule étant caractérisé en ce que l'impédance aux bornes d'entrée (1, 2) et l'impédance aux bornes de sortie (3, 4) de la cellule sont contrôlées par une unique tension $(V_{d1})$, par l'intermédiaire d'un circuit de contrôle (5), qui, à partir d'une tension variable $(V_{d1})$, délivre deux tensions de contrôle variables complémentaires (V1, V2) dont l'une (V1 ou V2) contrôle l'impédance d'entrée, et dont l'autre (V2 ou V1) contrôle l'impédance de sortie de la cellule.

2/ Cellule à impédance contrôlable selon la revendication 1, caractérisée en ce qu'elle constitue un atténuateur en π, comprenant une impédance variable $(Z_{P2})$ série entre une entrée (1) et une sortie (3) de la cellule, commandée par une première tension de contrôle (V1), et deux impédances variables $(Z_{P1}, Z_{P3})$ parallèles entre les entrées (1, 2) et les sorties (3, 4) de la cellule, respectivement, commandées par une seconde tension de contrôle (V2), les deux tensions de contrôle (V1, V2) étant délivrées par le circuit de contrôle (5).

3/ Cellule à impédance contrôlable selon la revendication 1, caractérisée en ce qu'elle constitue une réactance variable en T, comprenant deux impédances variables $(Z_{T1}, Z_{T3})$ séries entre une entrée (1) et une sortie (3) de la cellule, commandées par une première tension de contrôle (V1), et une impédance variable $(Z_{T2})$, parallèle, montée entre le point commun aux deux impédances série $(Z_{T1}, Z_{T3})$ et le point commun entrée-sortie (2,4) de la cellule, cette impédance parallèle $(Z_{T2})$ étant contrôlée par une seconde tension de contrôle (V2), les deux tensions de contrôle (V1, V2) étant délivrées par le circuit de contrôle (5).

4/ Cellule à impédance contrôlable selon la revendication 1, caractérisée en ce que les composants actifs qui constituent les impédances variables $(Z_1, Z_2, Z_3)$ sont des transistors à effet de champ, non polarisés, de type MESFET (T1, T2, T3), les tensions de contrôle (V1, V2) étant appliquées sur leurs grilles.

5/ Cellule à impédance contrôlable selon la revendication 1, caractérisée en ce que les composants actifs qui constituent les impédances variables ($Z_1$, $Z_2$, $Z_3$) sont des transistors à effet de champ (T1, T2, T'2, T3) sans grilles, se comportant en résistances actives (saturables), les tensions de commande (V1, V2) étant appliquées aux bornes d'accès des dites résistances actives.

6/ Cellules à impédance contrôlable selon la revendication 1, caractérisée en ce que les composants actifs qui constituent les impédances variables ($Z_1$, $Z_2$, $Z_3$) sont des diodes Schottky (D1, D2, D3) polarisées en inverse par les tensions de contrôle (V1, V2).

7/ Circuit de contrôle, pour cellule selon la revendication 1, délivrant deux tensions de sorties (V1, V2) variables complémentaires, variant simultanément en sens opposés, et dont la somme reste constante, caractérisé en ce qu'il comprend deux branches montées en parallèle, entre les deux pôles d'une alimentation (P), chaque branche étant constituée par un transistor et une résistance montés en série (T10 et R1, T20 et R2), une tension de commande ($V_{d1}$), variable, étant appliquée sur l'électrode de commande du transistor (T10) de la première branche, tandis qu'une tension de référence ($V_{d2}$), fixe, est appliquée sur l'électrode de commande du transistor (T20) de la seconde branche, les tensions de sorties (V1, V2) complémentaires étant prélevées, sur chaque branche, au point commun entre le transistor et la résistance.

8/ Circuit de contrôle selon la revendication 7 caractérisé en ce que, en vue de corriger la dissymétrie des caractéristiques de tensions de sorties (V1, V2) en fonction de la tension de commande ($V_{d1}$), différente de la tension de référence ($V_{d2}$), les résistances (R1, R2) sont dissymétriques.

9/ Circuit de contrôle selon la revendication 7, caractérisé en ce que sa source de courant (P) a une impédance élevée, de l'ordre de 200 ohms.

10/ Circuit de contrôle selon la revendication 7, caractérisé en ce qu'il est cascadable, une pluralité de tels circuits montés en parallèle entre les pôles d'une même alimentation (P), et commandés par une même tension de commande ($V_{d1}$), délivrant une pluralité de tensions de sorties (V1, V2....), en nombre pair et complémentaires deux à deux.

11/ Circuit de contrôle selon la revendication 7 caractérisé en ce que, en vue de linéariser une tension de sortie dans les faibles valeurs ($\leqslant 0,6$ V), celle-ci est appliquée comme tension d'entrée à un circuit correcteur qui comprend, alimenté par une source de courant auxiliaire (P'), un transistor (T7) dont le drain est en série avec une diode (D30) (cathode au drain) et une résistance (R13) reliée à la source de courant (P'), la tension de sortie linéaire étant prélevée à la cathode de la diode (D30).

12/ Circuit de contrôle selon la revendication 7, caractérisé en ce que, en vue de linéariser une tension de sortie dans les valeurs élevées ($\geqslant 0,6$ V), celle-ci est appliquée comme tension d'entrée à un circuit correcteur qui comprend, alimenté par une source de courant auxiliaire (P'), un transistor (T5) dont le drain est en série avec une diode (D10) (cathode au drain) et une première résistance (R21) reliée à la source de courant (P') une seconde résistance (R11) étant montée en parallèle aux bornes de la diode (D10), la tension de sortie linéaire étant prélevée à l'anode de la diode (D10).

0148706

1/4

FIG.1

FIG.2

FIG.3

FIG.4

FIG.5

FIG.6

**FIG.7**

$V_2$

$2+4$

$1$     $3$

$T_1+T_2+T_3$

$5$

$V_1$     $V_2$

$V_{d1}$    $V_{SS}$    $V_{d2}$

**FIG.8**

$2+4$

$V_2$   $T_1$     $T_3$   $V_2$

$1$     $3$

$T_2$   $V_1$   $T_2'$

$V_2$

$R$

$1$     $3$

$D_1$    $D_2$    $D_3$

$L$

$2+4$

**FIG.9**

0148706

**FIG.10**

**FIG.11**

**FIG.12**

**FIG.13**

# FIG.14

# FIG.15

# FIG.17

# FIG.16